(19) Europäisches Patentamt
European Patent Office
Office européen des brevets

(11) EP 2 169 372 B1

(12) **EUROPEAN PATENT SPECIFICATION**

(45) Date of publication and mention of the grant of the patent:
**28.11.2018 Bulletin 2018/48**

(21) Application number: **08765655.9**

(22) Date of filing: **16.06.2008**

(51) Int Cl.:
***G01L 1/24*** *(2006.01)* ***H05K 1/02*** *(2006.01)*
***H05K 3/12*** *(2006.01)*

(86) International application number:
**PCT/JP2008/060972**

(87) International publication number:
**WO 2009/008248 (15.01.2009 Gazette 2009/03)**

(54) **MATERIAL FOR PRESSURE MEASUREMENT**

MATERIAL ZUR DRUCKMESSUNG

MATÉRIAU POUR MESURE DE PRESSION

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **11.07.2007 JP 2007181846**

(43) Date of publication of application:
**31.03.2010 Bulletin 2010/13**

(73) Proprietor: **FUJIFILM Corporation**
**Tokyo 106-8620 (JP)**

(72) Inventors:
- **WATANABE, Tsutomu**
**Fujinomiya-shi**
**Shizuoka 418-8666 (JP)**
- **MATSUMOTO, Takayuki**
**Fujinomiya-shi**
**Shizuoka 418-8666 (JP)**

(74) Representative: **Grünecker Patent- und Rechtsanwälte**
**PartG mbB**
**Leopoldstraße 4**
**80802 München (DE)**

(56) References cited:
**JP-A- 2004 090 408**
**JP-B2- 57 024 852**
**JP-Y2- 3 025 180**
**US-A- 4 002 060**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 169 372 B1

Printed by Jouve, 75001 PARIS (FR)

## Description

### TECHNICAL FIELD

The present invention relates to a material for pressure measurement with which the distribution of pressure such as surface pressure is measured.

### BACKGROUND ART

Materials for pressure measurement have been used in applications to a step of laminating liquid crystal glass, solder printing onto a print substrate, and regulation of pressure between rollers. As the material for pressure measurement, there is a pressure measurement film represented for example by Prescale (trade name) provided by Fujifilm Corporation.

As an example of this pressure measurement film, a sheet for pressure measurement which utilizes a color forming reaction between a colorless electron-donating dye precursor and an electron-accepting compound has been disclosed (see, for example, Japanese Patent Application Publication (JP-B) No. 57-24852) to be estimated to enable measurement at pressure in the range of about 0.1 to 20 MPa. The pressure measurement film is characterized by being usable by cutting the film in an arbitrary size with adjustment to a measurement site. Moreover, the pressure measurement film, unlike so-called pressure sensitive copying paper causing a color forming reaction by high linear pressure with writing pressure, is characterized by being able to measure surface pressure.

In recent years, there is increasing necessity for measurement of the distribution of a minute pressure by virtue of higher functions and higher fineness of products. For lamination of liquid crystal panels for example, there is an increasing method of vacuum lamination by a request of a larger area. Measurement of pressure distribution in a range of the atmospheric pressure of 0.1 MPa or less becomes important. In solder printing onto a print substrate, finer formation of electronic parts and formulation of multilayer substrates are advancing, so that handling in a pressure region including a minute pressure of 0.1 MPa or less is increasing, and there is increasing demand for pressure measurement of a minute pressure of 0.1 MPa or less.

US 4 002 060 A discloses a pressure measurement sheet comprising a support wherein a layer containing microcapsules containing a color former and a layer containing adsorbent are provided on the same or opposite sides of said support.

### DISCLOSURE OF THE INVENTION

### PROBLEM TO BE SOLVED BY THE INVENTION

However, those materials for measurement of pressure or pressure distribution, used conventionally as described above, do not color in a pressure region of lower than 0.1 MPa, for example 0.05 MPa or so, or fail to provide a sufficient color density. Accordingly, there remains a problem that as described above, the measurement material cannot be used in a process wherein its slight pressure change influences quality variations of products, or the measurement material even when being coloring cannot be subjected to fine density analysis or regulation upon incorporation thereof by scanning or the like as data.

The invention was made in view of the circumstances described above, thereby allowing a material for pressure measurement to attain density visible or readable at a minute pressure (particularly, a pressure (preferably a surface pressure) of less than 0.1 MPa) and to enable measurement of pressure distribution at a minute pressure.

### MEANS FOR SOLVING THE PROBLEM

As a result of examination of the problem, the invention is based on the finding that in spite of the fact that the number of microcapsules per unit area of layer is relatively large in a color development system utilizing a color forming reaction between a colorless electron-donating dye precursor and an electron-accepting compound, the deformation volume of individual capsules deformed upon application of pressure would be suppressed by contacting the capsules with one another, thus making the capsules unlikely to breaking (that is, coloring). That is, the invention is based on the finding that the control of the amount of capsules present per unit area is effective in discriminating or reading a minute pressure (preferably a pressure of less than 0.1 MPa) or a pressure distribution thereof.

Specific means of completing the problem described above are as follows:

<1> A material for pressure measurement, comprising:

a color-forming layer having microcapsules containing a colorless electron-donating dye precursor; and
an electron-accepting compound that reacts with the colorless electron-donating dye precursor to form color after breakage of at least one of the microcapsules,
wherein the material has a color density difference (ΔD) of 0.02 or more before and after pressurization at 0.05 MPa,
wherein, when the median diameter of the microcapsules on a volume basis is A μm, 5000 to 30000 microcapsules having a diameter of (A + 5) μm or more are present per 2 cm × 2 cm area,
wherein the median diameter A (μm) on a volume basis is 10 to 40 μm, and
wherein the capsule wall of the microcapsules consists of polyurethane-urea and satisfies the following relationship: δ/D = from $1.0 \times 10^{-3}$ to $2.0 \times 10^{-2}$, where δ is a number-average wall thickness (μm) of the microcapsules, and D is a median diameter (μm) of the microcapsules on a volume basis.

<2> The material for pressure measurement according to <1>, wherein the median diameter A (μm) is from 15 to 35 μm on a volume basis, and 7000 to 28000 microcapsules having a diameter of (A + 5) μm or more are present per 2 cm × 2 cm area.
<3> The material for pressure measurement according to <1>, comprising a developer layer containing the electron-accepting compound and the color-forming layer containing microcapsules having the colorless electron-donating dye precursor included therein on a substrate, in this order from the side of the substrate.
<4> The material for pressure measurement according to <1>, comprising a material A having a developer layer containing the electron-accepting compound on a substrate, and a material B having a color forming layer containing a microcapsule having the colorless electron-donating dye precursor included therein on another substrate.
<5> The material for pressure measurement according to <3> or <4>, wherein each of the substrates is a plastic film or a synthetic paper.
<6> The material for pressure measurement according to <1>, wherein the wall thickness of the capsule wall of the microcapsules is in the range of from 0.005 to 2.0 μm.
<7> The material for pressure measurement according to <1>, wherein the wall thickness of the capsule wall of the microcapsules is from 0.06 to 0.28 μm.
<8> The material for pressure measurement according to <1>, wherein the wall thickness of the capsule wall of the microcapsules is from 0.07 to 0.27 μm.
<9> The material for pressure measurement according to <1>, wherein δ/D is from $2.0 \times 10^{-3}$ to $1.5 \times 10^{-2}$.

EFFECT OF THE INVENTION

According to the invention, there can be provided a material for pressure measurement which attains density visible or readable at a minute pressure (particularly a pressure (preferably a surface pressure) of less than 0.1 MPa) and enables measurement of pressure distribution at a minute pressure.

BEST MODE FOR CARRYING OUT THE INVENTION

Hereinafter, the material for pressure measurement of the invention will be described in detail.
The material for pressure measurement of the invention utilizes a color forming reaction between a colorless electron-donating dye precursor and an electron-accepting compound, and is constituted such that the color density difference (ΔD) becomes 0.02 or more before and after pressurization at 0.05 MPa.
Conventionally, coloring has been hardly obtained at a minute pressure of 0.05 MPa. In the invention, however, a minute pressure of 0.05 MPa is given, thereby making a density difference ΔD (≥ 0.02) not only visibly but also readable by scanning.
Accordingly, the invention enables detection and measurement of minute pressure difference and pressure distribution that are increased accompanied by higher functions and higher fineness of products in recent years.
In the invention, since the colorless electron-donating dye precursor that is one coloring component is included in microcapsules, and the number of microcapsules having a diameter of (A + 5) μm or more, relative to the median diameter of A μm on a volume basis, is 5000 to 30000 per 2 cm × 2 cm area, those microcapsules having a larger size than the prescribed size among the microcapsules having the colorless electron-donating dye precursor included therein can be allowed to be selectively present. In the invention, therefore, a ΔD of 0.02 or more, which is density not only visibly but also readable by scanning, is obtained.
When the median diameter of the microcapsules on a volume basis is A μm and then the number of microcapsules having a diameter of (A + 5) μm or more is 5000 or more per 2 cm × 2 cm area, the number of microcapsules which among those having the colorless electron-donating dye precursors included therein, have a relatively larger size to influence coloring is increased. Accordingly, higher color density is obtained and readability is improved. When the

number of microcapsules having (A + 5) μm or more is 30000 or less per 2 cm × 2 cm area, capsules liable to become capsule breakage (that is, coloring) at a minute pressure of 0.05 MPa.

As described above, the number of the microcapsules having a diameter of (A + 5) μm or more is 5,000 to 30,000, preferably 7,000 to 28,000, per 2 cm × 2 cm area, from the viewpoint of improving color density upon application of a minute pressure of 0.05 MPa, thereby improving visibility and readability in scanning.

The median diameter of the microcapsules on a volume basis is from 10 to 40 μm, preferably from 13 to 37 μm, more preferably from 15 to 35 μm, from the viewpoint of increasing color density at a minute pressure (particularly a pressure (preferably surface pressure) of less than 0.1 MPa), thereby improving visibility and readability in scanning.

In the foregoing, it is particularly preferable in the invention that when the median diameter of the microcapsules on a volume basis is 15 to 35 μm, the number of microcapsules having a diameter of (15 to 35 μm) + 5 μm or more is from 7,000 to 28,000 per 2 cm × 2 cm area, from the viewpoint of increasing color density at a pressure (preferably surface pressure) of less than 0.1 MPa, thereby improving visibility and readability in scanning.

The median diameter on a volume basis in the invention is a diameter $D^{50}$ wherein, when all of the microcapsules are divided into two groups with a particle diameter at which an accumulated amount of particle volume is 50% as a threshold, the total volume of particles on the larger-diameter side and the total volume of particles on the smaller-diameter side are an equal amount. The median diameter on a volume basis is a value calculated by applying a microcapsule liquid onto a support, photographing its surface at a magnitude of 150 with a light microscope, and measuring the size of every microcapsule in an area of 2 cm × 2 cm.

The material for pressure measurement of the invention is constituted by arranging (preferably applying), on a single substrate or separate substrates, a microcapsule having a colorless electron-donating dye precursor (also referred to hereinafter as " color former") and a solvent included therein, and an electron-accepting compound (also referred to hereinafter as "developer") coloring by reacting with the colorless electron-donating dye precursor.

When the material for pressure measurement of the invention is a so-called mono-sheet type of material is constituted arranged, on a single substrate, a microcapsule and an electron-accepting compound by coating and the like, the material for pressure measurement is composed of a substrate such as a sheet or film and, on the substrate, a developer-containing developer layer and a microcapsule-containing color forming layer, arranged from the side of the substrate. The material for pressure measurement is pressurized alone or by being put in a site for measuring pressure or pressure distribution.

When the material for pressure measurement of the invention is a so-called 2-sheet type of material is constituted arranged a microcapsule and an electron-accepting compound by applying respectively onto separate substrates, the material for pressure measurement is composed of a material A having a developer-containing developer layer on a substrate such as a sheet or film and a material B having a microcapsule-containing color forming layer on a substrate such as a sheet or film. In this material for pressure measurement, the surface (color forming layer surface) of the material B having the microcapsules present thereon, and the surface (developer layer surface) of the material A having the electron-accepting compound present thereon, are disposed in contact with each other, and then pressurized in a layered state by being put in a site for measuring pressure or pressure distribution.

Pressurization can be carried out by giving press of point, linear or surface (point pressure, linear pressure or surface pressure) in an arbitrary method. The invention is effective, particularly at a low pressure range of less than 0.1 MPa, in case a density difference in a coloring part for differentiating a minute pressure difference is small and a surface pressure for differential pressure is hardly grasped.

By this manner of pressurization, the microcapsules are broken to release inclusions containing a colorless electron-donating dye precursor, thereby reacting the colorless electron-donating dye precursor with an electron-accepting compound, to enable observation of coloring. At this time, the inclusions containing the colorless electron-donating dye precursor are emitted in a larger amount corresponding to a pressure to be pressurized, the amount of the colorless electron-donating dye precursor reacted with the electron-accepting compound is increased. Accordingly, dense coloring is obtained in the material for pressure measurement.

In the foregoing, the material for pressure measurement is composed preferably of the 2-sheet type material wherein the microcapsules having a colorless electron-donating dye precursor included therein, and an electron-accepting compound, are arranged by applying them onto separate substrates respectively, from the viewpoint of storability and handling characteristics.

(Substrate)

The substrate that constitutes the material for pressure measurement of the invention may be in the form of a sheet, film or plate, and the like. Specific examples include a paper, a plastic film and a synthetic paper, and the like. The material for pressure measurement, whether the mono-sheet type or the 2-sheet type, may be in the same form.

Specific examples of the paper may include a high-quality paper, a medium quality paper, a woody paper, an acid-free paper, an acid paper, a regenerated paper, a coated paper, a machine coated paper, an art part, a cast-coated

paper, a fine coated paper, a tracing paper, and a reclaimed paper. Specific examples of the plastic film may include polyester films such as a polyethylene terephthalate film, cellulose derivative films such as a cellulose triacetate, polyolefin films such as polypropylene and polyethylene, and a polystyrene film.

Specific examples of the synthetic paper include those (yupo etc.) having a large number of microvoids formed by biaxially stretching a polypropylene, a polyethylene terephthalate and the like, those consisting of synthetic fibers such as a polyethylene, a polypropylene, a polyethylene terephthalate and a polyamide, and those having these synthetic papers laminated on a part, one side or both sides of paper.

However, the invention is not limited thereto.

Above all, the plastic film and the synthetic paper are preferable, and the plastic film is more preferable, from the viewpoint of increasing color density by pressurization.

(Colorless electron-donating dye precursor)

The microcapsule contained in the color forming layer of the material for pressure measurement of the invention contains at least one kind of colorless electron-donating dye precursor.

The colorless electron-donating dye precursor included in the microcapsule may be used one known in pressure sensitive copying paper or pressure sensitive recording paper. For example, various compounds such as a triphenyl methane phthalide-based compound, a fluoran-based compound, a phenothiazine-based compound, an indolylphthalide-based compound, a leukoauramine-based compound, a rhodamine lactam-based compound, a triphenyl methane-based compound, a diphenylmethane-based compound, a triazene-based compound, a spiropyran-based compound and a fluorene-based compound may be used.

These compounds are described in detail in Japanese Patent Application Laid-Open (JP-A) No. 5-257272, and the colorless electron-donating dye precursors may be used alone or as a mixture of two or more thereof.

The molar extinction coefficient (ε) of the colorless electron-donating dye precursor is preferably higher from the viewpoint of improving coloring at a pressure (preferably surface pressure) of less than 0.1 MPa, thereby obtaining a high density at a minute pressure (increasing density change (density gradient) to pressure change). The molar extinction coefficient (ε) of the colorless electron-donating dye precursor is preferably 10,000 $mol^{-1}\cdot cm^{-1}\cdot L$ or more, more preferably 15,000 $mol^{-1}\cdot cm^{-1}\cdot L$ or more, even more preferably 25,000 $mol^{-1}\cdot cm^{-1}\cdot L$ or more.

Preferable examples of the colorless electron-donating dye precursor having ε in the above range include 3-(4-diethylamino-2-ethoxyphenyl)-3-(1-ethyl-2-methylindol-3-yl)-4-azaphthalide (ε = 61000), 3-(4-diethylamino-2-ethoxyphenyl)-3-(1-n-octyl-2-methylindol-3-yl)phthalide (ε = 40000), 3-[2,2-bis(1-ethyl-2-methylindol-3-yl)vinyl]-3-(4-diethylaminophenyl)-phthalide (ε = 40000),
9- [ethyl(3 -methylbutyl)amino] spiro [12H-benzo [a]xanthene-12,1'(3'H)isobenzofuran]-3'-on (ε = 34000), 2-anilino-6-dibutylamino-3-methylfluoran (ε = 22000),
6-diethylamino-3-methyl-2-(2,6-xylidino)-fluoran (ε = 19000),

2-(2-chloroanilino)-6-dibutylaminofluoran (ε = 21000),
3,3-bis(4-dimethylaminophenyl)-6-dimethylaminophthalide (ε = 16000), and
2-anilino-6-diethylamino-3-methylfluoran (ε = 16000), and the like.

When the colorless electron-donating dye precursor having the molar extinction coefficient (ε) in the range described above is used singly, or when the two or more the colorless electron-donating dye precursors having the molar extinction coefficient (ε) in the range described above are used as a mixture, the ratio of the colorless electron-donating dye precursors having a molar extinction coefficient (ε) of 10,000 $mol^{-1}\cdot cm^{-1}\cdot L$ or more, with respect to the total amount of the colorless electron-donating dye precursors, is preferably in the range of from 10% to 100% by mass, more preferably in the range of from 20% to 100% by mass, even more preferably in the range of from 30% to 100% by mass. When the ratio of the colorless electron-donating dye precursor is in the range described above, the material can improve coloring at a low pressure (preferably surface pressure) of less than 0.1 MPa, thereby attaining a high density at low pressure (increasing a density change (density gradient) to pressure change).

When two or more kinds of the colorless electron-donating dye precursors are used, two or more of those having ε of 10,000 $mol^{-1}\cdot cm^{-1}\cdot L$ or more are preferably used in combination.

The molar extinction coefficient (ε) can be calculated from an absorbance when the colorless electron-donating dye precursor is dissolved in 95% aqueous acetic acid solution.
Specifically, 95% aqueous acetic acid solution of the colorless electron-donating dye having its density adjusted to have an absorbance of 1.0 or less can be measured, the ε is computed by the following formula:

$$\text{Molar extinction coefficient } (\varepsilon) = C/(A \times B)$$

wherein the length of a measurement cell is A cm, the density of the colorless electron-donating dye is B mol/L, and the absorbance is C.

From the viewpoint of improving coloring at low pressure (preferably less than 0.1 MPa), the amount of the colorless electron-donating dye precursor (for example, its coating amount) is preferably 0.1 to 5 g/m$^2$, more preferably 0.1 to 4 g/m$^2$, even more preferably 0.2 to 3 g/m$^2$, in terms of mass after drying.

(Solvent)

The microcapsule in the invention includes at least one kind of solvent together with the colorless electron-donating dye precursor.

The solvent included in the microcapsules may be used one may be known for use in pressure sensitive copying paper. Examples of the solvent include an aromatic hydrocarbon, for example, alkyl naphthalenes such as a diisopropyl naphthalene, diaryl alkanes such as a 1-phenyl-1-xylylethane, alkyl biphenyls such as an isopropyl biphenyl, other triaryl methanes, alkyl benzenes, benzyl naphthalenes, diaryl alkylenes, and aryl indanes, and the like; and aliphatic hydrocarbons such as a dibutyl phthalate and an isoparaffin, and the like, natural animal and vegetal oils such as a soybean oil, a corn oil, a cottonseed oil, a rapeseed oil, an olive oil, a palm oil, a castor oil and a fish oil, and the like, and natural high-boiling fractions such as mineral oils, and the like. The solvents may be used alone or as a mixture of two or more thereof.

If necessary, solvents having a boiling point of 130°C or less, for example, ketones such as a methyl ethyl ketone, esters such as an ethyl acetate, alcohols such as an isopropyl alcohol can also be added as an auxiliary solvent.

(Method of Preparing the Microcapsule)

The microcapsule in which a colorless electron-donating dye precursor and a solvent are included can be produced by an arbitrary method known per se, for example, methods such as an interfacial polymerization method, an internal polymerization method, a phase separation method, an external polymerization method, or a coacervation process.

The wall material of the microcapsules consists of polyurethane-urea.

Preparation of a dispersion liquid of the microcapsules of a polyurethane-urea wall, including the colorless electron-donating dye precursor, may be carried out by a method known for use in pressure sensitive copying paper. For example, a solution (oil phase) containing the colorless electron-donating dye precursor and a multivalent isocyanate dissolved in a solvent is emulsified dispersed in a hydrophilic solution (for example water or the like; aqueous phase) containing a water-soluble polymer (capsule wall-forming materials such as a polyol or a polyamine) and then oil droplets in the obtained emulsified dispersed liquid are covered with polyurethane-urea to form microcapsules. At this time, a heating enables to advance a polymer formation reaction via droplet interface to form microcapsule walls.

During the step of microencapsulation, reaction control agents such as a multivalent hydroxy compound, a multivalent amine and the like may be added. Specific examples of the multivalent hydroxy compound may include an aliphatic or aromatic multivalent alcohol, a hydroxy polyester, a hydroxy polyalkylene ether, and an alkylene oxide adduct of a multivalent amine. Among them, the aliphatic or aromatic multivalent alcohol and the alkylene oxide adduct of a multivalent amine are preferable, and the alkylene oxide adduct of a multivalent amine is more preferable.

Any multivalent amine may be used as long as it has 2 or more -NH groups or $-NH_2$ groups in a molecule. Specific examples may include, for example, aliphatic multivalent amines such as a diethylene triamine, a triethylene tetramine, an 1,3-propylene diamine and a hexamethylene diamine, and the like; epoxy compound adducts of an aliphatic multivalent amine; alicyclic multivalent amines such as a piperazine and the like; and heterocyclic diamines such as a 3,9-bis-aminopropyl-2,4,8,10-tetraoxaspiro-(5,5)undecane.

The amount of the multivalent hydroxy compound and the multivalent amine added is suitably determined depending on the type and amount of multivalent isocyanate used and a desired hardness of the capsule film. When the multivalent hydroxy compound and the multivalent amine are added, the ratio (mass ratio) of "the total amount of the multivalent hydroxy compound and/or the multivalent amine : the amount of the multivalent isocyanate" is preferably 0.1 : 99.9 to 30 : 70, more preferably 1 : 99 to 25 : 75. The amount of the multivalent hydroxy compound added is preferable such that ratio by mass of the multivalent isocyanate : multivalent hydroxy compound is preferably 99.9 : 0.1 to 70 : 30, more preferably 99 : 1 to 75 : 25, even more preferably 98 : 2 to 80 : 20.

As addition timing of the multivalent hydroxy compound or the multivalent amine, the multivalent hydroxy compound or the multivalent amine may be added in advance into a solvent or an auxiliary solvent for solving the colorless electron-donating dye precursor, or may be added before or after dispersion by emulsification.

As emulsifying agents, various amphoteric polymers, various ionic polymers, various nonionic polymers, for example a gelatin, a starch, a carboxymethyl cellulose, a polyvinyl alcohol, a polyalkyl benzene sulfonate, a polyoxyethylene sulfate, a polyoxy alkyl ether and its modified product, and an isobutylene-maleic anhydride copolymer, and the

like may be added into the hydrophilic solution.

The multivalent isocyanate may be used one is known for use in pressure sensitive copying paper. Examples may include an isocyanurate of hydrogenated xylylene diisocyanate (generally called hydrogenated XDI), an isocyanurate of isophorone diisocyanate (generally called IPDI), 4,4'-diphenylmethane diisocyanate, a hexamethylene diisocyanate/trimethylol propane adduct, a hexamethylene diisocyanate burette body, an isocyanurate body of hexamethylene diisocyanate, a compound that an aliphatic diol (for example, alkylene diol) bound via an urethane bond to an isocyanurate body of hexamethylene diisocyanate, a polymethylene polyphenyl isocyanate, a carbodiimide-modified diphenylmethane diisocyanate, a tolylene diisocyanate/trimethylol propane adduct, a xylylene diisocyanate/trimethylol propane adduct, an isocyanurate body of tolylene diisocyanate, a hydrogenated xylylene diisocyanate/trimethylol propane adduct, an isophorone diisocyanate/trimethyl propane adduct, a burette body of xylylene diisocyanate, and tris-(p-isocyanatophenyl)thiophosphate. The multivalent isocyanate may be used alone or as a mixture of two or more thereof.

The microcapsule may contain additives if necessary in addition to the colorless electron-donating dye precursor, a solvent and an auxiliary solvent. The additives may include an ultraviolet absorber, a light stabilizer, an antioxidant agent, wax and an odor suppresser.

The mass ratio of the solvent and the colorless electron-donating dye precursor contained in the microcapsule (the solvent: the precursor) is preferably in the range of 98 : 2 to 30 : 70, more preferably in the range of 97 : 3 to 40 : 60, even more preferably in the range of 95 : 5 to 50 : 50, from the viewpoint of coloring.

The wall thickness of the capsule wall of the microcapsules may be suitably selected without limitation as long as the microcapsule may be broken at a minute pressure (at least 0.05 MPa). Among them, from the viewpoint of attaining excellent coloring at a low pressure of less than 0.1 MPa, the preferable wall thickness is in the range of 0.005 to 2.0 μm, more preferably in the range of 0.05 to 0.30 μm, and more preferably 0.06 to 0.28 μm. Particularly, the wall thickness of the capsule wall is preferably 0.07 to 0.27 μm.

The microcapsules having the colorless electron-donating dye precursor included therein are made of a polyurethane-urea having urethane bond as a wall material and satisfy the relationship shown in formula 1 below, in attaining excellent coloring at low pressure (preferably less than 0.1 MPa). By constituting the microcapsule that satisfies this formula, a coloring system in which coloring occurs easily even at a low pressure region (preferably in a pressure region of less than 0.1 MPa) can be formed. In the formula 1 below, $\delta$ represents the number-average wall thickness (μm) of the microcapsule, and D represents the median diameter (μm) of the microcapsule on a volume basis.

$$1.0 \times 10^{-3} \leq \delta/D \leq 2.0 \times 10^{-2} \qquad \text{formula 1}$$

When the $\delta$/D value is in the range described above, the capsule has good balance between capsule size and capsule wall thickness and attains good coloring in a low-pressure region (preferably in a pressure region of 0.1 MPa or less) without leakage of capsule contents with time due to becoming too thin.

In the invention, the wall thickness refers to the thickness of a resin film (so-called a capsule wall) that forms capsule particle of the microcapsule, and the number-average wall thickness (μm) refers to an average value of capsule walls of 5 microcapsules averaged under a scanning electron microscope.

In the range of the $\delta$/D value, the $\delta$/D value is preferably $2.0 \times 10^{-3}$ to $1.5 \times 10^{-2}$, more preferably $3.0 \times 10^{-3}$ to $1.3 \times 10^{-2}$, from the viewpoint of attaining excellent coloring (coloration) in a low pressure region (preferably in a pressure region of 0.1 MPa or less).

(Preparation of Color forming layer-Forming Preparation Liquid)

The microcapsules can be obtained as a dispersion liquid as described above, and the dispersion liquid of the microcapsules may be used directly as a preparation liquid (particularly a coating liquid) for forming a color forming layer containing the colorless electron-donating dye precursor. The dispersion liquid of the microcapsules obtained as described above may be used as a preparation liquid (particularly a coating liquid) by adding buffering agent such as a fine powder of starch or starch derivatives, a cellulose fiber powder and the like, water-soluble high-molecular-weight binders such as a polyvinyl alcohol, hydrophobic high-molecular-weight binders such as a vinyl acetate-based copolymer latexe, an acrylate-based copolymer latexe, and a styrene/butadiene copolymer latexe, a fluorescent whitening agent, an antifoaming agent, a penetrating agents, an ultraviolet absorber, and an antiseptic agent.

The preparation liquid (particularly a coating liquid) obtained in this manner can be provided, onto a substrate, by applying and the like, and dried, and then, a color forming layer constituting the material for pressure measurement may be formed.

When the color forming layer-forming preparation liquid is used as a coating liquid, a method of coating the coating liquid can be carried out by coating and drying with a usual coating machine. Specific examples of the coating

machine may include an air knife coater, a rod coater, a bar coater, a curtain coater, a gravure coater, an extrusion coater, a die coater, a slide bead coater, and a blade coater, and the like.

When the material for pressure measurement of the invention is a 2-sheet type of material constituted by coating separate substrates with the microcapsule having a colorless electron-donating dye precursor included therein and an electron-accepting compound, respectively, for example the coating liquid is coated, on desired sheet-shaped substrates, directly or via another layer thereon respectively, and dried, whereby the sheet material having at least the color forming layer formed thereon may be obtained. Alternatively, when the material for pressure measurement is a mono-sheet type of material constituted by coating a single sheet-shaped substrate with the microcapsule having a colorless electron-donating dye precursor included therein and an electron-accepting compound, for example the coating liquid is coated onto a developer layer described below formed on a desired substrate and dried, whereby the material for pressure measurement may be obtained.

(Electron-accepting compound)

The developer layer of the material for pressure measurement of the invention contains at least one kind of electron-accepting compound (developer).

The electron-accepting compound contained in the developer layer may include an inorganic compound and an organic compound. Specific examples of the inorganic compound may include clay materials such as an acid clay, an activated earth, an attapulgite, a zeolite, a bentonite and a kaolin. The organic compounds may include a metal aromatic carboxylate, a phenol formaldehyde resin, and a carboxylated temper phenol resin metal salt. Among them, the acid clay, the activated earth, the zeolite, the kaolin, the metal aromatic carboxylate, and the carboxylated temper phenol resin metal salt are preferable, and the acid clay, the activated earth, the kaolin, and the metal aromatic carboxylate are more preferable.

Preferable specific examples of the metals aromatic carboxylates may include zinc salts, nickel salts, aluminum salts and calcium salts of 3,5-di-t-butylsalicylic acid, 3,5-di-t-octylsalicylic acid, 3,5-di-t-nonylsalicylic acid, 3,5-di-t-dodecylsalicylic acid, 3-methyl-5-t-dodecylsalicylic acid, 3-t-dodecylsalicylic acid, 5-t-dodecylsalicylic acid, 5-cyclohexylsalicylic acid, 3,5-bis($\alpha$,$\alpha$-dimethylbenzyl)salicylic acid, 3-methyl-5-($\alpha$-methylbenzyl)salicylic acid, 3-($\alpha$,$\alpha$-dimethylbenzyl)-5-methylsalicylic acid, 3-($\alpha$,$\alpha$-dimethylbenzyl)-6-methylsalicylic acid, 3-($\alpha$-methylbenzyl)-5-($\alpha$,$\alpha$-dimethylbenzyl)salicylic acid, 3-($\alpha$,$\alpha$-dimethylbenzyl)-6-ethylsalicylic acid, 3-phenyl-5-($\alpha$,$\alpha$-dimethylbenzyl)salicylic acid, a carboxy-modified terpene phenol resin, and a salicylate resin that is a 3,5-bis($\alpha$-methylbenzyl)salicylic acid/benzyl chloride reaction product, and the like.

(Preparation of Developer Dispersion Liquid)

When the electron-accepting compound is the inorganic compound described above, the developer dispersion liquid can be prepared by dispersing the inorganic compound mechanically in an aqueous system. When the electron-accepting compound is an organic compound, the organic compound can be dispersed mechanically in an aqueous system or dissolved in an organic solvent.

Specifically, a method described in JP-A No. 8-207435 may be referred to.

(Preparation of Developer Layer-Forming Preparation Liquid)

The electron-accepting compound dispersion liquid prepared as described above may be used directly as a preparation liquid (particularly a coating liquid) for forming a developer layer containing the electron-accepting compound. To the preparation liquid (particularly a coating liquid) for forming the developer layer may be added synthetic or natural polymer materials such as a styrene-butadiene copolymer latex, a vinyl acetate-based latex, an acrylic ester-based latex , a polyvinyl alcohol, a polyacrylic acid, a maleic anhydride-styrene copolymer, a starch, a casein, a gum arabic, a gelatin, a carboxymethyl cellulose and a methyl cellulose as binders. To the preparation liquid (particularly the coating liquid) may be added a kaolin, a fired kaolin, a kaolin aggregate, a heavy calcium carbonate, a light calcium carbonate having various forms (rice-shaped, horn-shaped, spindle-shaped, bur-shaped, globular-shaped, aragonite column-shaped, and amorphous, and the like), a talc, and a rutile type or anatase type titanium dioxide, as pigments. If necessary, a fluorescent whitening agent, an antifoaming agent, a penetrating agent, and an antiseptic agent may be added to the preparation liquid (particularly the coating liquid).

When the developer layer-forming preparation liquid is used as a coating liquid, a method of coating the coating liquid can be carried out by coating and drying with a usual coating machine. Specific examples of the coating machine may include a blade coater, a rod coater, an air knife coater, a curtain coater, a gravure coater, a bar coater, a roll coater, an extrusion coater, a die coater, a slide bead coater, and a blade coater.

When the material for pressure measurement of the invention is a 2-sheet type of material constituted by coating

separate substrates with the microcapsule having a colorless electron-donating dye precursor included therein and an electron-accepting compound, respectively, for example the coating liquid containing the developer is coated, on desired sheet-shaped substrate, directly or via another layer thereon, and dried, whereby the sheet material having at least the developer layer formed thereon may be obtained. Alternatively, when the material for pressure measurement is a mono-sheet type of material constituted by coating a single sheet-shaped substrate with the microcapsule having a colorless electron-donating dye precursor included therein and an electron-accepting compound, for example the coating liquid containing the developer is coated onto a desired substrate and dried, whereby the developer layer constituting the material for pressure measurement may be obtained.

The amount of the electron-accepting compound (developer) in the developer layer (which in the case of coating, is a coating amount) is preferably 0.1 to 30 $g/m^2$ based on mass after drying, more preferably 3 to 20 $g/m^2$ in the case of the inorganic compound or 0.1 to 5 $g/m^2$ in the base of the organic compound. This amount (which in the case of coating, is a coating amount) is more preferably 5 to 15 $g/m^2$ in the case of the inorganic compound or 0.2 to 3 $g/m^2$ in the case of the organic compound.

## EXAMPLES

Hereinafter, the invention will be described in more detail with reference to the examples. Unless otherwise noted, "parts" refer to parts by mass.

### [Example 1]

- Preparation of Electron-donating dye precursor-Included Microcapsule Liquid (A) -

9 parts of Compound (A) below were dissolved as a colorless electron-donating dye precursor in 70 parts of diaryl ethane to obtain a solution A. Then, 0.4 part of an ethylene diamine/butylene oxide adduct dissolved in 1 part of methyl ethyl ketone was added to the solution A under stirring, to obtain a solution B. Further, 2 parts of tolylene diisocyanate/trimethylol propane adduct dissolved in 1 part of methyl ethyl ketone were added to the solvent B under stirring, to obtain a solution C. Then, the solution C was added to a solution having 6 parts of polyvinyl alcohol dissolved in 150 parts of water and then emulsification-dispersed. 300 parts of water were added to the emulsified liquid after emulsification dispersion, and then the emulsified liquid was heated to 70°C under stirring, followed by stirring for 1 hour and then cooling. By adding water thereto to regulate its concentration, a colorless electron-donating dye precursor-included microcapsule liquid (A) having a solid content of 18% was obtained.

The number-average wall thickness ($\delta$) of the resulting microcapsule was 0.11 $\mu$m, and the median diameter $D^{50}$ thereof on a volume basis was 20 $\mu$m. The number-average wall thickness was a mean value of capsule walls of 5 microcapsules determined with a scanning electron microscope, and the median diameter was calculated by applying the microcapsule liquid onto a desired support, then photographing it at a magnification of 150 times under a light microscope and measuring the size of every microcapsule in the range of 2 cm $\times$ 2 cm area. $\delta$/D was 0.006.

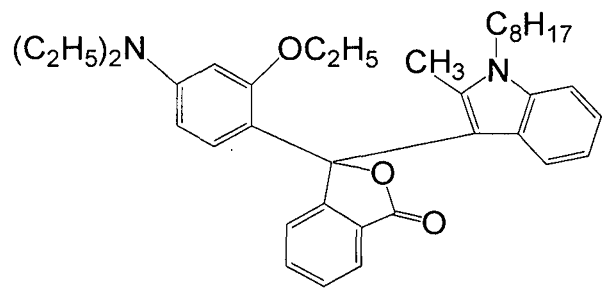

Compound (A)

- Preparation of Electron-donating dye precursor-Included Microcapsule Liquid (B) -

The colorless electron-donating dye precursor-included microcapsule liquid (A) obtained above was subjected repeatedly several times to cross-flow filtration treatment through a filter having a pore diameter of 25 $\mu$m, thereby removing those electron-donating dye precursor-included microcapsules having size of 25 $\mu$m or more. By adding water thereto to regulate its concentration, a colorless electron-donating dye precursor-included microcapsule liquid (B) having a solid content of 18% was obtained.

- Preparation of Electron Donating Colorless Dye Sheet -

50 parts of the colorless electron-donating dye precursor-included microcapsule liquid (A) were mixed with 50 parts of the colorless electron-donating dye precursor-included microcapsule liquid (B). The microcapsule liquid thus mixed was applied with a bar coater and dried on a polyethylene terephthalate (PET) sheet of 75 μm in thickness such that the weight thereof after drying became 5.0 g/m$^2$, thereby forming a color-forming layer. In this manner, the electron donating colorless dye sheet was obtained.

- Preparation of Developer-Containing Liquid -

5 parts of 40% aqueous sodium hydroxide solution and 300 parts of water were added to 100 parts of sulfuric acid-treated activated earth (electron-accepting compound) and then dispersed with a homogenizer, followed by adding 50 parts of 10% aqueous sodium casein and 30 parts of styrene-butadiene latex, to prepare a developer-containing liquid containing an electron-accepting compound (developer).

- Preparation of Developer Sheet -

The resulting developer-containing liquid was applied with a bar coater and dried on a polyethylene terephthalate (PET) sheet of 75 μm in thickness such that the amount of the applied solids became 10 g/m$^2$ to form a developer layer, and thereby a developer sheet was obtained.

The material for pressure measurement of 2-sheet type consisting of the electron donating colorless dye sheet and the developer sheet according to the invention was prepared in the manner described above.

- Evaluation and Measurement -

The microcapsule liquid (A) and the material for pressure measurement thus obtained were evaluated and measured as described below. The results of evaluation and measurement are shown in Table 1 below.

(1) Color Density

The resulting material for pressure measurement was cut in a size of 5 cm × 5 cm, and the electron donating colorless dye sheet and the developer sheet were layered such that the surface of the color forming layer of the electron donating colorless dye sheet and the surface of the developer layer of the developer sheet are disposed in contact with each other. The layered sheet was put between 2 glass plates having a smooth surface, and then loaded with a weight thereon, thereby applying each pressure shown in Table 1, to develop a color. Thereafter, the 2 layered sheets were released from each other, and a densitometer RD-19 (Gretag Macbeth) was used to measure the density ($D^A$) of a coloring part formed on the developer sheet. Separately, an initial density ($D^B$) of the unused developer sheet was measured in the same manner as above. By subtracting the initial density $D^B$ from the density $D^A$, the color density $\Delta D$ was determined and evaluated under the following evaluation criteria. "B" or more is in a practically allowable range.

- Evaluation Criteria -

A: ($\Delta D > 0.06$): color forming was evidently recognized, and density was high.
B: ($0.03 < \Delta D \leq 0.06$): color forming was evidently recognized.
C: ($0.01 \leq \Delta D \leq 0.03$): color forming was faintly recognized.
D: ($\Delta D < 0.01$): color forming was not recognized.

(2) Number of Microcapsules

By observing the surface of the color forming layer of the electron donating colorless dye sheet under a light microscope, the number of microcapsules having a diameter of 25 μm ((A + 5) μm) or more among those microcapsules having a median diameter of A = 20 μm was measured per 2 cm × 2 cm area.

(3) Readability

The electron donating colorless dye sheet and the developer sheet obtained above were cut in a size of 20 cm

× 20 cm and layered such that the surface of the color forming layer of the electron donating colorless dye sheet and the surface of the developer layer of the developer sheet were faced with each other. This layered sheet was pressurized via a glass plate at 0.10 MPa over the whole surface, to develop a color on the whole surface. By reading the density distribution of the sheet with a pressure image analysis system (trade name: FPD-9210, manufactured by Fujifilm Corporation), the in-plane distribution of pressure was analyzed. The evaluation was conducted under the following evaluation criteria.

- Evaluation Criteria -

A: Density distribution could be read and in-plane pressure distribution could be analyzed.
B: Density distribution could not be read and in-plane pressure distribution could not be analyzed.

[Example 2]

80 parts of the colorless electron-donating dye precursor-included microcapsule (A) and 20 parts of the colorless electron-donating dye precursor-included microcapsule (B), both of which were prepared in Example 1, were mixed with each other. The microcapsule liquid thus mixed was applied with a bar coater and dried on a polyethylene terephthalate (PET) sheet of 75 μm in thickness such that the weight thereof after drying became 5.0 g/m$^2$, to give an electron donating colorless dye sheet. This electron donating colorless dye sheet was used in evaluation and measurement in the same manner as in Example 1. The results of evaluation and measurement are shown in Table 1.

[Comparative Example 1]

The colorless electron-donating dye precursor-included microcapsule (A) prepared in Example 1 was applied with a bar coater and dried on a polyethylene terephthalate (PET) sheet of 75 μm in thickness such that the weight thereof after drying became 5.0 g/m$^2$, to give a comparative electron donating colorless dye sheet. This electron donating colorless dye sheet was used in evaluation and measurement in the same manner as in Example 1. The results of evaluation and measurement are shown in Table 1.

[Comparative Example 2]

20 parts of the colorless electron-donating dye precursor-included microcapsule (A) and 80 parts of the colorless electron-donating dye precursor-included microcapsule (B), both of which were prepared in Example 1, were mixed with each other. The microcapsule liquid thus mixed was applied with a bar coater and dried on a polyethylene terephthalate (PET) sheet of 75 μm in thickness such that the weight thereof after drying became 5.0 g/m$^2$, to give a comparative electron donating colorless dye sheet. This electron donating colorless dye sheet was used in evaluation and measurement in the same manner as in Example 1. The results of evaluation and measurement are shown in Table 1.

(Table 1)

| | Capsule liquid (A) : (B) | Number of capsules having a diameter of 25μm or more (A=20μm) | Color density ΔD | | | Readability |
|---|---|---|---|---|---|---|
| | | | 0.03 MPa | 0.05 MPa | 0.1 MPa | |
| Example 1 | 50:50 | 17860 | (0.02) (C) | (0.04) (B) | (0.09) (A) | A |
| Example 2 | 80:20 | 7130 | (0.04) (B) | (0.06) (B) | (0.10) (A) | A |
| Comparative Example 1 | 100:0 | 35050 | (0.00) (D) | (0.00) (D) | (0.01) (C) | B |
| Comparative Example 2 | 20:80 | 29120 | (0.00) (D) | (0.00) (D) | (0.00) (D) | B |

As shown in Table 1, evidently visible coloring was obtained in the Examples, even at a low surface pressure

of less than 0.1 MPa including 0.05 MPa. In the Comparative Examples, on the other hand, coloring was low and visible density could not be obtained at a low surface pressure of less than 0.1 MPa.

## Claims

1. A material for pressure measurement, comprising:

   a color-forming layer having microcapsules containing a colorless electron-donating dye precursor; and
   an electron-accepting compound that reacts with the colorless electron-donating dye precursor to form color after breakage of at least one of the microcapsules,
   **characterized in that**,
   the material has a color density difference ($\Delta D$) of 0.02 or more before and after pressurization at 0.05 MPa,
   wherein, when the median diameter of the microcapsules on a volume basis is A $\mu m$, 5000 to 30000 microcapsules having a diameter of (A + 5) $\mu m$ or more are present per 2 cm $\times$ 2 cm area,
   wherein the median diameter A ($\mu m$) on a volume basis is 10 to 40 $\mu m$, and
   wherein the capsule wall of the microcapsules consists of polyurethane-urea and satisfies the following relationship: $\delta/A$ = from $1.0 \times 10^{-3}$ to $2.0 \times 10^{-2}$, where $\delta$ is a number-average wall thickness ($\mu m$) of the microcapsules, and A is the median diameter ($\mu m$) of the microcapsules on a volume basis.

2. The material for pressure measurement according to claim 1, wherein the median diameter A ($\mu m$) is from 15 to 35 $\mu m$ on a volume basis, and 7000 to 28000 microcapsules having a diameter of (A + 5) $\mu m$ or more are present per 2 cm $\times$ 2 cm area.

3. The material for pressure measurement according to claim 1, comprising a developer layer containing the electron-accepting compound and the color-forming layer containing the microcapsules having the colorless electron-donating dye precursor included therein on a substrate, in this order from the side of the substrate.

4. The material for pressure measurement according to claim 1, comprising a material A having a developer layer containing the electron-accepting compound on a substrate, and a material B having the color forming layer containing the microcapsules having the colorless electron-donating dye precursor included therein on another substrate.

5. The material for pressure measurement according to claim 3 or 4, wherein each of the substrates is a plastic film or a synthetic paper.

6. The material for pressure measurement according to claim 1, wherein the wall thickness of the capsule wall of the microcapsules is in the range of from 0.005 to 2.0 $\mu m$).

7. The material for pressure measurement according to claim 1, wherein the wall thickness of the capsule wall of the microcapsules is from 0.06 to 0.28 $\mu m$.

8. The material for pressure measurement according to claim 1, wherein the wall thickness of the capsule wall of the microcapsules is from 0.07 to 0.27 $\mu m$.

9. The material for pressure measurement according to claim 1, wherein $\delta/A$ is from $2.0 \times 10^{-3}$ to $1.5 \times 10^{-2}$.

## Patentansprüche

1. Material zur Druckmessung, umfassend:

   eine farbbildende Schicht mit Mikrokapseln, die eine farblose elektronenabgebende Farbstoffvorstufe enthalten; und
   eine elektronenaufnehmende Verbindung, welche nach dem Zerbrechen von wenigstens einer der Mikrokapseln mit der farblosen elektronenabgebenden Farbstoffvorstufe unter Bildung einer Farbe reagiert,
   **dadurch gekennzeichnet, dass** das Material eine Farbdichtedifferenz ($\Delta D$) von 0,02 oder mehr vor und nach einer Druckbeaufschlagung mit 0,05 MPa aufweist,
   wobei, wenn der mittlere Durchmesser der Mikrokapseln auf einer Volumenbasis A $\mu m$ beträgt, 5000 bis 30000

Mikrokapseln mit einem Durchmesser von (A + 5) μm oder mehr pro 2 cm x 2 cm Fläche vorhanden sind, wobei der mittlere Durchmesser A (μm) auf einer Volumenbasis 10 bis 40 μm beträgt, und wobei die Kapselwand der Mikrokapseln aus Polyurethan-Harnstoff besteht und die folgende Beziehung erfüllt: $\delta/A = 1{,}0 \times 10^{-3}$ bis $2{,}0 \times 10^{-2}$, wobei δ eine zahlengemittelte Wanddicke (μm) der Mikrokapseln ist und A der mittlere Durchmesser (μm) der Mikrokapseln auf einer Volumenbasis ist.

**2.** Material zur Druckmessung gemäß Anspruch 1, wobei der mittlere Durchmesser A (μm) 15 bis 35 μm auf einer Volumenbasis beträgt und 7000 bis 28000 Mikrokapseln mit einem Durchmesser von (A + 5) μm oder mehr pro 2 cm x 2 cm Fläche vorhanden sind.

**3.** Material zur Druckmessung gemäß Anspruch 1, umfassend eine Entwicklerschicht, die die elektronenaufnehmende Verbindung enthält, und die farbbildende Schicht, die die Mikrokapseln mit der farblosen elektronenabgebenden Farbstoffvorstufe darin eingeschlossen enthält, auf einem Substrat, in dieser Reihenfolge von der Seite des Substrats her.

**4.** Material zur Druckmessung gemäß Anspruch 1, umfassend ein Material A mit einer Entwicklerschicht, die die elektronenaufnehmende Verbindung enthält, auf einem Substrat, und ein Material B mit der farbbildenden Schicht, die die Mikrokapseln mit der farblosen elektronenabgebenden Farbstoffvorstufe darin eingeschlossen enthält, auf einem anderen Substrat.

**5.** Material zur Druckmessung gemäß Anspruch 3 oder 4, wobei jedes von den Substraten eine Kunststofffolie oder ein synthetisches Papier ist.

**6.** Material zur Druckmessung gemäß Anspruch 1, wobei die Wanddicke der Kapselwand der Mikrokapseln im Bereich von 0,005 bis 2,0 μm liegt.

**7.** Material zur Druckmessung gemäß Anspruch 1, wobei die Wanddicke der Kapselwand der Mikrokapseln 0,06 bis 0,28 μm beträgt.

**8.** Material zur Druckmessung gemäß Anspruch 1, wobei die Wanddicke der Kapselwand der Mikrokapseln 0,07 bis 0,27 μm beträgt.

**9.** Material zur Druckmessung gemäß Anspruch 1, wobei $\delta/A$ $2{,}0 \times 10^{-3}$ bis $1{,}5 \times 10^{-2}$ beträgt.

## Revendications

**1.** Matériau pour mesure de pression, comprenant:

une couche de formation de couleur ayant des microcapsules contenant un précurseur de colorant donneur d'électrons incolore; et
un composé acceptant les électrons qui réagit avec le précurseur de colorant donneur d'électrons incolore pour former une couleur après la rupture d'au moins l'une des microcapsules,
**caractérisé en ce que**
le matériau présente une différence de densité de couleur (ΔD) égale ou supérieure à 0,02 avant et après pressurisation à 0,05 MPa,
dans lequel, lorsque le diamètre médian des microcapsules sur une base volumique est de A μm, 5000 à 30000 microcapsules ayant un diamètre de (A + 5) μm ou plus sont présentes par zone de 2 cm x 2 cm,
dans lequel le diamètre médian A (μm) sur la base du volume est de 10 à 40 μm, et dans lequel la paroi de la capsule des microcapsules est constituée de polyuréthane-urée et vérifie la relation suivante:
$\delta/A$ = de $1{,}0\times10^{-3}$ à $2{,}0 \times 10^{-2}$, où δ est un épaisseur moyenne de la paroi (μm) des microcapsules et A est le diamètre médian (μm) des microcapsules sur une base en volume.

**2.** Matériau pour mesure de pression selon la revendication 1, dans lequel le diamètre médian A (μm) est compris entre 15 et 35 μm en volume, et entre 7 000 et 28 000 microcapsules ayant un diamètre de (A + 5) μm ou plus sont présentes par zone de 2 cm x 2 cm.

**3.** Matériau pour mesure de pression selon la revendication 1, comprenant une couche de révélateur contenant le

composé acceptant les électrons et la couche de formation de couleur contenant les microcapsules avec le précurseur de colorant donneur d' électrons incolore inclus dans celui-ci sur un substrat, dans cet ordre à partir du côté du substrat.

4. Matériau pour mesure de pression selon la revendication 1, comprenant un matériau A avec une couche de révélateur contenant le composé acceptant les électrons sur un substrat,
et un matériau B ayant la couche de formation de couleur contenant les microcapsules avec la précurseur de colorant donneur d'électrons incolore inclus dans celui-ci sur un autre substrat.

5. Matériau pour mesure de pression selon les revendications 3 ou 4, dans lequel chacun des substrats est un film plastique ou un papier synthétique.

6. Matériau de mesure de pression selon la revendication 1, dans lequel l'épaisseur de la paroi de la capsule des microcapsules se situe dans la plage de 0,005 à 2,0 μm.

7. Matériau de mesure de pression selon la revendication 1, dans lequel l'épaisseur de la paroi de la capsule des microcapsules se situe dans la plage de 0.06 à 0.28 μm.

8. Matériau de mesure de pression selon la revendication 1, dans lequel l'épaisseur de la paroi de la capsule des microcapsules se situe dans la plage de 0.07 à 0.27 μm.

9. Matériau pour mesure de pression selon la revendication 1, dans lequel $\delta/A$ est compris entre $2,0 \times 10^{-3}$ et $1,5 \times 10^{-2}$.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 57024852 B
- US 4002060 A
- JP 5257272 A
- JP 8207435 A